# EUROPEAN PATENT SPECIFICATION

(11) **EP 1 608 049 B1**
(45) Date of publication and mention of the grant of the patent: **01.08.2007**
(21) Application number: 05253523.4
(22) Date of filing: 08.06.2005
(51) Int. Cl.: H01S 5/183, H01S 5/14

(54) **External cavity plural wavelength laser system**
Mehrwellenlängenlasersystem mit externem Resonator
Source laser à cavité externe avec multiples longueurs d'onde

(30) Priority: 19.06.2004 KR 2004045848; 08.10.2004 US 960698
(43) Date of publication of application: 21.12.2005
(73) Proprietor: SAMSUNG ELECTRONICS CO., LTD., Suwon-si, Gyeonggi-do (KR)
(72) Inventor: Kim, Taek, Seongnam-si Gyeonggi-do (KR)
(74) Representative: Greene, Simon Kenneth

(56) References cited:
- EP-A- 1 411 608
- WO-A-02/47223
- WO-A-20/04086577
- US-A1- 2002 172 237
- US-A1- 2003 156 617
- US-B1- 6 243 407
- US-B1- 6 535 541
- CALVEZ S ET AL: "OPTIMIZATION OF AN OPTICALLY PUMPED 1.3-MUM GAINAS VERTICAL-CAVITY SURFACE-EMITTING LASER" IEEE PHOTONICS TECHNOLOGY LETTERS, IEEE INC. NEW YORK, US, vol. 14, no. 2, February 2002 (2002-02), pages 131-133, XP001123167 ISSN: 1041-1135
- LEE C P ET AL: "DUAL-WAVELENGTH BRAGG REFLECTORS USING GAAS/ALAS MULTILAYERS" ELECTRONICS LETTERS, IEE STEVENAGE, GB, vol. 29, no. 22, 28 October 1993 (1993-10-28), pages 1980-1981, XP000407347 ISSN: 0013-5194

## Description

The present invention relates to a laser system capable of emitting two or more coherent wavelengths of light, and more particularly to both optically pumped and electrically pumped semiconductor vertical external cavity surface emitting lasers (VECSEL) with selectively positioned quantum wells to control the power of light at each of said wavelengths.

There is an increasing need for multiple wavelength laser sources. For instance, the increased popularity of laser display devices presents a need for a red (R)(∼625nm), green (G)(∼532 nm) and blue (B)(∼460nm) laser source. Currently, the present inventors know of no available semiconductor lasers that emit both blue and green wavelengths.

Diode pumped solid state (DPSS) lasers combined with second harmonic generation (SHG) technology can provide green laser light at 532 nm, but such devices are relatively expensive at this time. High power blue laser light is still very difficult to achieve, due to low recombination efficiency.

Infrared wavelength, optically pumped semiconductor (OPS) vertical external (or coupled) cavity surface emitting lasers (VECSEL), such as disclosed in U.S. Patent No. 6,347,109, can provide a visual wavelength laser beam with SHG technology, such as disclosed in U.S. Patent No. 6,370,168. Similarly, electrically pumped VECSELs, such as disclosed in U.S. Patent Nos. 6,614,827 and 6,243,407, can provide a visual wavelength laser beam with SHG technology.

Generally, OPS-VECSELs conceptually combine the approaches of diode-pumped solid-state lasers and semiconductor quantum-well (QW) vertical-cavity surface-emitting lasers (VCSEL). In these approaches, a semiconductor chip of the laser system is composed of a QW active layer and a highly reflective distributed Bragg reflector (DBR). Usually the QW active layer is designed to enhance gain performance to achieve high power, such as provided by a resonant periodic gain (RPG) structure, such as disclosed by Mark Kuznetsov et al., "Design and Characteristics of High-Power (>0.5-W CW) Diode-Pumped Vertical-External-Cavity Surface-Emitting Semiconductor Lasers with Circular TEM00 Beams," IEEE J. of Selected Topics in Quantum Electronics, Vol. 5, No. 3, May/June 1999.

FIG. 1 is a simplified cross-section of a conventional VECSEL, such as disclosed in U.S. patent No. 6,370,168. Referring to FIG. 1, the conventional VECSEL 10 includes a heat sink 11 attached to a chip. The chip includes a substrate 12 upon which are stacked a lower, high reflectivity multi-layer mirror 13, such as a semiconductor layer of distributed Bragg reflectors (DBR), a gain region 14, such as a multi-quantum well gain region with a resonant periodic gain (RPG), and an upper anti-reflective coating 15. A lasing cavity is formed between an external spherical mirror 16, through which part of the laser beam λ2 can pass as the laser output, and the high-reflectivity mirror 13 of the chip. A pump beam from a multi-mode laser source 17 of a different wavelength λ1 is projected onto the anti-reflective coating 15. An optical non-linear crystal (not shown) can be added to double the frequency of the lasing light λ2.

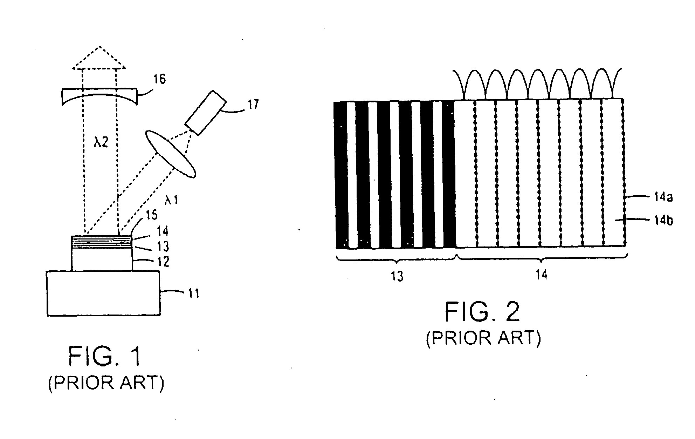

Referring to FIG. 2; the structure of the conventional DBR 13 and RPG active region 14 is shown in relation to the standing wave of the cavity structure. As can be seen, the RPG 14 is made up of QWs 14a and spacers 14b. The QWs 14a are positioned at the antinodes of the standing wave to maximize gain in the pumped laser light λ2 through in-quantum-well absorption of the pumping laser light λ1, which is favored to avoid excessive heat generation. Light generated from this active region 14 of a conventional VECSEL is projected through the external mirror 16 as a continuous wave (CW) laser light output.

in approaches such as these, the pump diode laser 17 (in the case of optical pumping), the cooling element, and the optics determine the laser system price. The semiconductor chip (the substrate 12, the DBR 13, the RPG 14 and the anti-reflective coating 15) represents a small fraction of the total cost. These systems generate a single wavelength λ2 of laser light as the output.

The present invention provides a vertical external cavity surface emitting layer (VECSEL) system, which can produce more than one wavelength of coherent light without significantly increasing cost of manufacture or cost of operation. The semiconductor chip can be designed to emit two or more different wavelengths of light, and the rest of the laser system, representing the majority of the manufacturing cost, are used in the production of both wavelengths of light.

EP 1411608 describes an external cavity organic laser. In embodiments, multiple gain regions are provided at locations corresponding to the peaks of intensity patterns at multiple wavelengths.

US 6,535,541 describes a vertical cavity laser with multiple active regions for emitting at multiple wavelengths.

WO 02/47223 describes a vertical cavity laser with multiple quantum wells, arranged at antinodes of a standing wave.

According to the invention, there is provided a laser system according to claim 1.

The gain-structure includes a first plurality of first active layers and a second plurality of second active layers spaced apart by spacer layers. The first active layers may be positioned at antinodes of a first standing wavelength of a first frequency, and second active layers are positioned at antinodes of a second standing wavelength of a second frequency. The number of first active layers and the number of second active layers are selected to control the relative power output of light at each of the first and the second wavelengths.

In some embodiments the first wavelength of the first active layers is shorter than the second wavelength of the second active layers, and more of the second active layers than the first active layers are located where antinodes of the standing waves of the first and second wavelengths coincide. In this way, the relative power of the laser light output can be balanced.

In some embodiments, the mirror-structure of the laser pump structure includes a periodic heterostructure each of the periods including at least two quarterwave, high refractive layers H, at least two spacer layers S and at least one quarterwave, low refractive layer L. The multi-layer mirror can be a stack in the form of (L(HS)^{D})^{N}, or in the form of (H(LS)^{D})^{N} wherein D and N are positive integers and D is greater than 1.

In still further embodiments, an optically-nonlinear crystal located in the laser-resonator is arranged to double at least one of the first frequency of laser-radiation and the second frequency of laser-radiation, thereby providing frequency-doubled radiation.

The above and other features and advantages of the present invention will become more apparent by the following description exemplary embodiments thereof, to which the present invention is not limited, with reference to the attached drawings. It is noted that not all of possible embodiments of the present invention will exhibit each and every, or any, of the advantages described herein.

FIG. 1 is a simplified schematic diagram of a conventional vertical external cavity surface emitting laser (VECSEL).

FIG. 2 illustrates an example of a conventional RPG structure.

FIG. 3 is a simplified schematic diagram of an exemplary vertical external cavity surface emitting laser.

FIG. 4 is a simplified vertical cross-sectional view of an optically-pumped chip structure according to an exemplary embodiment of the present invention.

FIG. 5 is a simplified vertical cross-sectional view of an electrically-pumped chip structure according to an exemplary embodiment of the present invention.

FIG. 6 illustrates an example of a RPG structure according to an exemplary embodiment of the present invention.

FIG. 7 is a graph showing the reflectance of a dual band high reflectivity DBR according to an exemplary embodiment of the present invention.

FIG. 8 is a graph showing the reflectance of a dual band high reflectivity DBR according to another exemplary embodiment of the present invention.

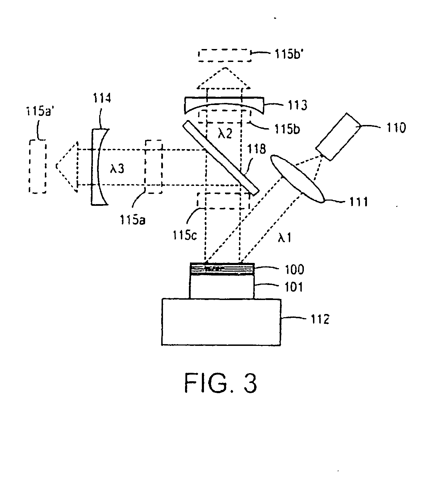

FIG. 3 schematically illustrates one example of a vertical external cavity surface-emitting laser (VECSEL). The basic VECSEL has a well-known lasing structure, which includes an active region where lasing occurs and upper and lower semiconductor layers between which the active region is located, but there are many variations of the basic structure. The present invention is not limited to this particular structure and can be adopted in a variety of different lasing structures that involve a plurality of quantum wells.

As shown in FIG. 3, the laser system in the case of an optical pumping scheme includes a pump laser diode 110, which projects laser light through a collimating lens 111 to project a collimated light beam of light at a pump wavelength λ1 onto a laser pump structure 100. The pump light does not have to be from a diode, and does not have to be coherent light. The laser pump structure 100 is grown on a substrate 101, which in turn is mounted on a heat-sink 112. The substrate can be GaAs, or any material on which the lasing pump structure can be grown.

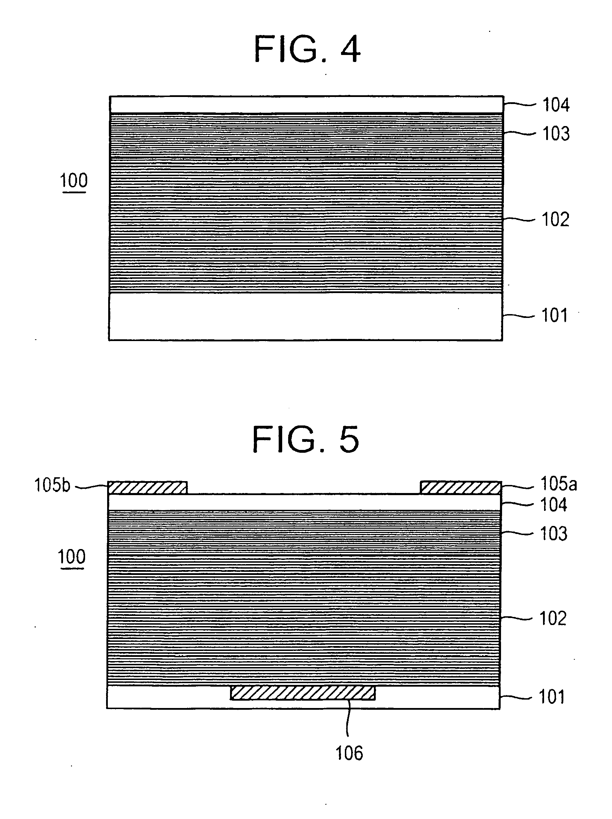

The laser system also includes a laser-resonator having a resonator axis and including a mirror structure 102 (FIGS. 4 and 5) of the laser pump structure 100 and an external mirror structure including first and second external mirrors 113, 114 in the illustrated embodiment, spaced apart from the gain-structure 103, and a transmissive wavelength-selective element 118.

The transmissive wavelength-selective element 118 is located in the laser-resonator for selecting the first frequency of the laser-radiation within a gain bandwidth characteristic of the composition of the gain structure 103 to pass through to the first external mirror 113 and for selecting the second frequency of the laser radiation with a gain bandwidth characteristic of the composition of the gain structure 103 to reflect to the second external mirror 114. Hence, the wavelength of light impinging on the first and second external mirrors 113, 114 is different from each other in the embodiment shown in FIG. 3. The transmissive wavelength-selective element 118 can be a dichroic mirror, a birefringent filter, an etalon, or any suitable element that separates light according to wavelength on two different paths.

The reflectivity of the external mirrors 113, 114 can be in the range of 98% to 99.99% for the first and second wavelengths λ2, λ3, with the light passing through the external mirrors 113, 114 representing the output of the exemplary laser system of FIG. 3. The external mirror structure 113, 114 can include a concave mirror to ensure single transverse mode operation. The radius of the curvature is mainly a function of cavity length and aperture diameter.

Additionally, an optically-nonlinear crystal 115 can be located to double at least one of the first frequency λ2 or the second frequency λ3 of the laser radiation, or both, thereby providing a frequency-doubled radiation. Optically-nonlinear crystals can be KTP, LiNbO₃, periodically poled LiNbO₃, KTN or KnbO₃, or any material capable of affecting the frequency of light impinging on it in a controlled and reproducible manner.

As illustrated in FIG. 3, the optically-nonlinear crystal 115 can be located within the laser-resonator such as illustrated by the phantom lines marked with reference number 115c on the resonator path common to the laser light of the first wavelength λ2 and the second wavelength λ3. Alternatively, the optically-nonlinear crystal 115 can be located after the transmissive wavelength-selective element 118 has separated the first wavelength light and the second wavelength light from each other. This is illustrated in FIG. 3 by the optically-nonlinear crystals shown in phantom and referenced by reference numerals 115a and 115b. This embodiment has the added advantage of being able to frequency double either the first wavelength λ2 or the second wavelength λ3, or both first and second wavelengths λ2 and λ3 by either placing or not placing the non-linear elements 115a or 115b in the relevant locations.

In still a further variation of the optically pumped laser system shown in FIG. 3, the optically-nonlinear crystal 115 can be outside the resonator either on the path of the laser radiation of the first wavelength λ2 once it passes through the first mirror 113 as illustrated by reference number 115b', or on the optical path of the laser light having the second wavelength λ3 after it has passed through the second mirror 114, as illustrated by reference numeral 115a'.

It should also be noted that an electrically pumped laser system is substantially identical to that shown in FIG. 3, including all of the variations described above, but with a different chip structure, as shown in FIG. 5.

FIG. 4 illustrates a chip structure of the laser pump structure including a multilayer gain structure 103, which is mounted on or grown on a multilayer mirror structure 102. As illustrated, the mirror structure 102 is a dual band distributed Bragg reflector.

The multi-layer gain-structure 103, or active layer, is a resonant periodic gain structure. The active layer is formed of one of an indium gallium arsenide (InGaAs) quantum well, an indium gallium arsenide nitride (InGaAsN) quantum well, and an In(Ga)(N)As quantum dot.

Additionally, as illustrated in FIGS. 4 and 5, there is a substrate 101, which can be omitted in certain embodiments and a top layer 104, which can either be an anti-reflection layer or a reflective mirror. If the top layer 104 is a reflective mirror, the laser system effectively will have two resonator cavities. The first resonator cavity is located between the multilayer mirror structure 102 and the reflective mirror 104, i.e., in the multilayer gain structure 103. The second resonator, as explained above, would be between the multilayer mirror structure 102 of the gain structure 100 and the external mirror structure 113, 114.

The example illustrated in FIG. 4 is designed for optical pumping in accordance with the embodiment of FIG. 3. FIG. 5, in contrast, includes top layer contacts 105a and 105b (e.g., metal, ohmic contacts), as well as a bottom contact 106 (e.g., metal, ohmic contacts), which can be similar in structure as to the electrodes and the operation, to the laser disclosed in U.S. Patent No. 6,614,827, for instance. In either case, whether an optical pump or an electrical pump, the pump source is arranged to deliver pump energy to the gain structure 103 for generating laser-radiation in the laser-resonator.

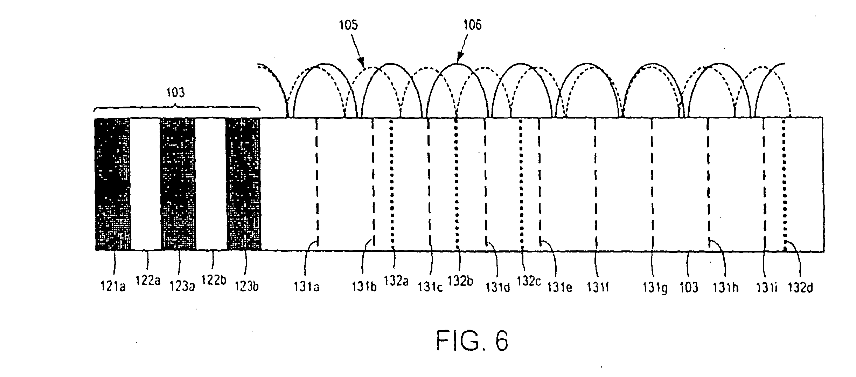

In FIG. 6, the laser pump structure 100 is illustrated to show the relative position of quantum wells with respect to the standing wave for two wavelengths of light.

Dual band optical reflectors are known such as disclosed in Stephane Calvez et al., "Optimization of an Optically Pumped 1.3-µm GaInNAs Vertical-Cavity Surface-Emitting Laser," IEEE Photonics Tech. Letters, Vol. 14, No. 2, Feb. 2002 and C.P. Lee et al., "Dual-Wavelength Bragg Reflectors Using GaAs/AlAs multilayers," Electronic Letters, 28 October 1993, Vol. 29, No. 22.
As illustrated in FIG. 6, the mirror structure 102 can be configured as a dual band distributed Bragg reflector composed of a plurality of periodic heterostructures, each comprising an equal number of layers H having a high refractive index and spacer layers S, and at least one low refractive index layer L. For clarity of illustratation, in FIG. 6 only one such heterostructure is shown, comprising low refractive index layer 121 a, high refractive index layers 122a, 122b, and spacer layers 123a, 123b. Exemplary material for the high refractive index lasers H are AlₓGa₁₋ₓAs (0≤ x<1) and exemplary material for the low refractive index lasers L are Al_{y}Ga_{1-y}As (0<y≤ 1). Exemplary material for the space layers S are Al_{z}Ga_{1-z}As (0<z<1). The layers can be formed using any suitable technique, including but not limited to MOCVD and MBE. Post-epitaxy ion implantation can be used to provide electrical confinement in electrically pumped embodiments. Lasing efficiency can be further enhanced using by employing optical confinement, such as by selective oxidation techniques to form a buried oxide aperture as is known. This provides both transverse electrical and optical confinement in AlₓGa₍₁₋ₓ₎As-based VCSELs and VECSELs lattice matched to GaAs substrates.

Among the novel aspect of the present invention is that the mirror structure 102 of the laser pump structure 100 is a multilayer stack in the form of (L(HS)^{D})^{N}, wherein D and N are positive integers and D is greater than 1. While only low refractive index layer 121 a, high refractive index layers 122a and 122b and spacer layers 123a and 123b are shown in FIG. 6, it should be noted that a larger number, for instance, 30, such layers would be utilized in a practical embodiment. Usually DBR layers end with low refractive index layer L.

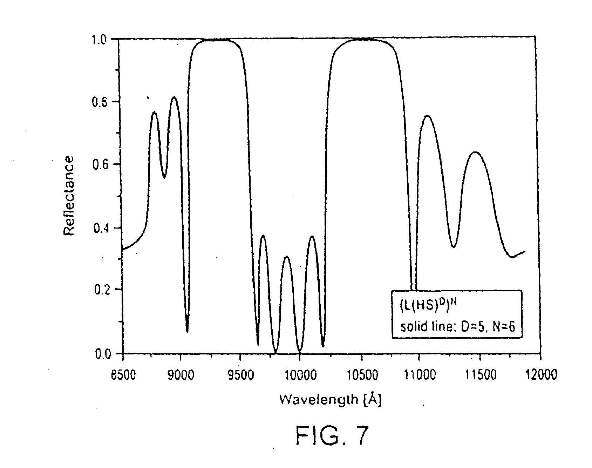

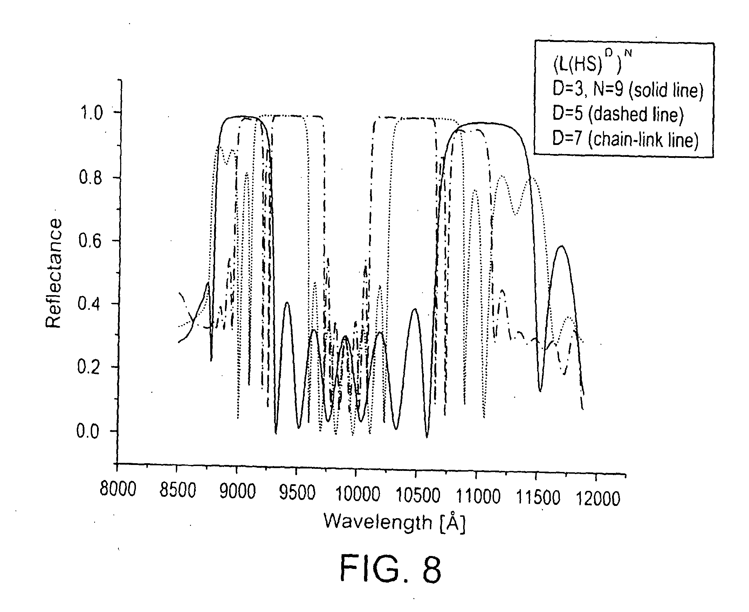

The number of layers in the distributed Bragg reflector has an effect on performance, as illustrated in FIGS. 7 and 8. In the graph of FIG. 7, a dual band or even a triple band high reflectivity mirror can be formed using the equation (L(HS)^{D})^{N}, where D equals 5 and N equals 6 (i.e., layers in the order of LHSHSHSHSHSLHSHSHSHSHSLHSHSHSHSHSLHSHSHSHSHSLHSHSHSHS HSLHSHSHSHSHS).

FIG. 8, on the other hand, includes overlapping graphs showing the reflectance according to wavelength with the equation (L(HS)^{D})^{N}, where D equals 3 and N equals 9 as the solid line, D equals 5 as to the dashed line and D equals 7 as to the chain link line.

Alternatively, the multilayer stack for the mirror structure 102 following the equation (H(LS)^{D})^{N} and where D equals 5 and N equals 6, the layers would be in the order of HLSLSLSLSLS HLSLSLSLSLS HLSLSLSLSLS HLSLSLSLSLS HLSLSLSLSLS HLSLSLSLSLS.

Turning back to FIG. 6, the resonant periodic gain structure 103 is illustrated to show the relationship between quantum wells 131, 132 and the nodes and antinodes of the standing waves. Specifically, quantum wells 131a-131i are positioned at the antinodes of the standing wave having a wavelength of 920 nm, for instance. Similarly, the quantum wells 132a-132d are positioned at the antinodes of the standing wave for a wavelength of 1060 nm.

Because part of the 920 nm light absorbs in the 1060 nm quantum wells, meaning that there is not a loss of light insofar as the light is absorbed and generates 1060 nm light, the intensity of the 1060 nm laser light can be stronger than that of the 920 nm laser light. It should be noted after review of the resonant periodic gain structure 103 that there are more quantum wells 131 for the 920 nm wavelength than the 1060 nm wavelength. The number of each type of quantum well can be controlled to control, and optionally balance the optical power of the two wavelengths. This is especially true of the quantum well in the position where there are two antinode positions that either overtap or are close to each other (e.g., ± 20% of the distance between antinodes, although there is no clear criterion).

In instances where the node of the 920 nm standing wave intersects or is contiguous with a quantum well for the 1060 nm wavelengths, the quantum well, such as quantum well 132b, does not see any of the 920 nm light. If a standing wave node is co-located on a quantum well, there is no amplification. However, in other locations, the 920 nm light intersects the spaces between the quantum wells 132 and 131 and the energy thereof used to generate 1060 nm light. The intensity of the 1060 nm light can be adjusted to be stronger than it would otherwise be. It should also be noted that the barrier layers can be either absorption layers or transparent to the pumping light. The absorption of light in the barrier layer creates holes and electrons which transported to the QW contributing light generation in there. But it also creates heat. A balance should be struck insofar as the maximum light output power is limited by heat generation in current embodiments.

The present invention is therefore useful even in color display devices when combined with nonlinear optical elements. The wavelengths of 920 nm and 1060 nm are common and, with frequency doubling, will result in green and blue laser lights which can be balanced relative to one another.

The active region includes an active layer 103, but can also include cladding layers between which the active layer 103 is sandwiched. The active layer 103 can include a quantum well layers and barrier layers, between which the quantum well layer is located.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A laser system, comprising:
a laser structure including a multi-layer gain-structure (103) adjacent to a dual-wavelength mirror-structure (102) for reflecting light with a high reflectivity at a first wavelength and a second wavelength;
said gain-structure including a plurality of first active layers (131) for generating light at the first wavelength and a plurality of second active layers (132) for generating light at the second wavelength spaced apart by barrier layers;
a laser-resonator (102, 113, 114) having a resonator axis, said laser-resonator formed between said dual-wavelength mirror structure (102) of said laser structure, and an external mirror structure (113, 114) spaced apart from said gain-structure (103); and
a pump source (110) arranged to deliver pump energy to said gain-structure (103) for generating laser-radiation in said laser-resonator;
**characterised in that** said external mirror structure includes a first external mirror (113), a second external mirror (114) and a transmissive wavelength-selective element (118) located in said laser-resonator to separate light by wavelength on two different paths for selecting said first wavelength of said gain-structure to reach the first external mirror (113) and for selecting said second wavelength of said gain-structure to reach the second external mirror (114).

2. A laser system according to claim 1 wherein the first active layers (131) are positioned at antinodes of a first standing wave in the laser resonator (102, 113) of the first wavelength and the second active layers (132) are positioned at antinodes of a second standing wave in the laser resonator (102,114) of the second wavelength, and wherein the number of first active layers (131) and the number of second active layers (132) control the relative power output of light at each of the first and the second wavelengths.

3. The laser of claim 1 or 2, wherein the first wavelength is shorter than the second wavelength, and more of said second active layers (132) than said first active layers (131) are located where antinodes of said standing waves of said first and second wavelengths coincide.

4. The laser of claim 1, 2 or 3, wherein said dual-wavelength mirror-structure (102) includes a periodic heterostructure each of the periods comprising at least two high refractive layers H, at least two spacer layers S and at least one low refractive layers L.

5. The laser of claim 4, wherein said multi-layer mirror is a stack in the form of (L(HS)^{D})^{N}, wherein D and N are positive integers and D is greater than 1.

6. The laser of claim 4, wherein said multi-layer mirror is a stack in the form of (H(LS)^{D})^{N}, wherein D and N are positive integers and D and N are greater than 1.

7. The laser of any preceding claim, further comprising an optically-nonlinear crystal (115) located in said laser-resonator, and arranged to double at least one of the frequency of the first wavelength laser radiation and the frequency of the second wavelength laser radiation.

8. The laser of claim 7, wherein the optically-nonlinear crystal (1156) is located in said laser-resonator between said transmissive wavelength-selective element (118) and said first mirror (113) and arranged to double the frequency of said first wavelength laser radiation, thereby providing frequency-doubled radiation.

9. The laser of claim 7, wherein the optically-nonlinear crystal (115a) is located in said laser-resonator between said transmissive wavelength-selective element (118) and said second mirror (114) and arranged to double the frequency of said second wavelength laser radiation, thereby providing frequency-doubled radiation.

10. The laser of claim 1, further comprising an optically-nonlinear crystal (115a', 115b') located outside said laser-resonator, and arranged to double at least one of the frequency of the first wavelength laser radiation and the frequency of the second wavelength laser radiation, thereby providing frequency-doubled radiation.

11. The laser of claim 7, wherein the optically-nonlinear crystal (115c) is located in said laser-resonator between said transmissive wavelength-selective element and said multi-layer mirror-structure.

12. The laser of any preceding claim, wherein said pump source is a pump-light source (110) arranged to deliver pump-radiation to said gain-structure for generating laser-radiation in said laser-resonator.

13. The laser of any of claims 1 to 11, wherein said pump source is a pump-electron source arranged to deliver pump-electrons to said gain-structure for generating laser-radiation in said laser-resonator.

14. The laser of any preceding claim, wherein said first and second active layers (131, 132) each comprise a semiconductor material selected from the group consisting of lnₓ Ga₁₋ₓAs_{y}P_{1-y}, InₓGa₁₋ₓAs, GaₓIn₁₋ₓN_{y}As_{1-y} and Ga₁₋ₓAs_{y}Sb where 0.0<x<1.0. and 0.0<y<1.0., x and y being independently selectable for each of the first and second active layers

15. The laser of any preceding claim, wherein the first and the second wavelengths generated by the first and second active layers have values of about 1060 and 920 nanometers, respectively.

16. The laser of any preceding claim, wherein said first active layers (131) of said gain-structure are layers of a semiconductor material having a composition In_{0.1}Ga_{0.9}As and said first wavelength is 920 nm.

17. The laser of any preceding claim 1, wherein said second active layers (132) of said gain-structure are layers of a semiconductor material having a composition In_{0.25}Ga_{0.75}As and said second wavelength is 1060 nm.

18. The laser of any preceding claim, further comprising a heat-sink (112) in thermal contact with said laser pump structure.

19. The laser of any preceding claim, further comprising a heat-sink in thermal contact with said laser structure, said heat-sink being of a material having a thermal expansion coefficient which matches the thermal expansion coefficient of said laser structure.

20. The laser system of claim 13, further comprising ohmic contacts located to inject electrons into said active layers.

21. The laser system of claim 13, further comprising a current confinement structure.

22. The laser system of claim 1, wherein said laser structure comprises a GaAs substrate and said dual-wavelength mirror-structure (102) includes AlₓGa₁₋ₓAs layers and Al_{y}Ga_{1-y}As layers, where 0.0≤x<1.0 and 0.0<y≤1.0.

## Patentansprüche

1. Lasersystem umfassend:
eine Laserstruktur mit einer mehrschichtigen Verstärkerstruktur (103) benachbart zu einer Doppelwellenlängenspiegelstruktur (102) zum Reflektieren von Licht mit einem hohen Reflexionsvermögen bei einer ersten Wellenlänge und einer zweiten Wellenlänge;
wobei die Verstärkerstruktur eine Mehrzahl von ersten aktiven Schichten (131) zum Erzeugen von Licht bei der ersten Wellenlänge und eine Mehrzahl von zweiten aktiven Schichten (132) zum Erzeugen von Licht bei der zweiten Wellenlänge aufweist, die durch Barriereschichten beabstandet sind;
einen Laserresonator (102, 113, 114) mit einer Resonatorachse, wobei der Laserresonator zwischen der Doppelwellenlängenspiegelstruktur (102) der Laserstruktur und einer externen Spiegelstruktur (113, 114) ausgebildet ist, die von der Verstärkerstruktur (103) beabstandet ist; und
eine Pumpquelle (110) so ausgebildet, dass sie Pumpenergie an die Verstärkerstruktur (103) zum Erzeugen von Laserstrahlung im Laserresonator liefert; **dadurch gekennzeichnet, dass** die externe Spiegelstruktur einen ersten externen Spiegel (113), einen zweiten externen Spiegel (114) und ein wellenlängenselektives Transmissionselement (118) im Laserresonator gelegen aufweist, so dass Licht durch die Wellenlänge auf zwei verschiedenen Wegen getrennt wird, damit die erste Wellenlänge der Verstärkerstruktur so ausgewählt wird, dass sie den ersten externen Spiegel (113) erreicht, und die zweite Wellenlänge der Verstärkerstruktur so ausgewählt wird, dass sie den zweiten externen Spiegel (114) erreicht.

2. Lasersystem nach Anspruch 1, wobei die ersten aktiven Schichten (131) an Schwingungsbäuchen einer ersten stehenden Welle im Laserresonator (102, 113) der ersten Wellenlänge positioniert sind, und die zweiten aktiven Schichten (132) an Schwingungsbäuchen einer zweiten stehenden Welle im Laserresonator (102, 114) der zweiten Wellenlänge positioniert sind, und wobei die Anzahl der ersten aktiven Schichten (131) und die Anzahl der zweiten aktiven Schichten (132) die relative Leistungsausgabe an Licht bei jeder der ersten und zweiten Wellenlänge steuert.

3. Laser nach Anspruch 1 oder 2, wobei die erste Wellenlänge kürzer ist als die zweite Wellenlänge und mehr der zweiten aktiven Schichten (132) als der ersten aktiven Schichten (131) an der Stelle gelegen sind, an der Schwingungsbäuche der stehenden Wellen der ersten und zweiten Wellenlänge zusammenfallen.

4. Laser nach Anspruch 1, 2 oder 3, wobei die Doppelwellenlängenspiegelstruktur (102) eine periodische Heterostruktur aufweist, wobei jede der Perioden mindestens zwei Schichten H mit hohem Brechungsindex, mindestens zwei Abstandhalterschichten S und mindestens eine Schicht L mit niedrigem Brechungsindex umfasst.

5. Laser nach Anspruch 4, wobei der mehrschichtige Spiegel ein Stapel in der Form (L(HS)^{D})^{N} ist, worin D und N positive ganz Zahlen sind und D größer als 1 ist.

6. Laser nach Anspruch 4, wobei der mehrschichtige Spiegel ein Stapel in der Form (H(LS)^{D})^{N} ist, worin D und N positive ganz Zahlen sind und D und N größer als 1 sind.

7. Laser nach einem der vorhergehenden Ansprüche, ferner umfassend einen optisch nichtlinearen Kristall (115), der im Laserresonator gelegen und so ausgebildet ist, dass er die Frequenz der Laserstrahlung der ersten Wellenlänge und/oder die Frequenz der Laserstrahlung der zweiten Wellenlänge verdoppelt.

8. Laser nach Anspruch 7, wobei der optisch nichtlineare Kristall (115b) im Laserresonator zwischen dem wellenlängenselektiven Transmissionselement (118) und dem ersten Spiegel (113) gelegen und so ausgebildet ist, dass er die Frequenz der Laserstrahlung der ersten Wellenlänge verdoppelt, wodurch eine frequenzverdoppelte Strahlung erhalten wird.

9. Laser nach Anspruch 7, wobei der optisch nichtlineare Kristall (115a) im Laserresonator zwischen dem wellenlängenselektiven Transmissionselement (118) und dem zweiten Spiegel (114) gelegen und so ausgebildet ist, dass er die Frequenz der Laserstrahlung der zweiten Wellenlänge verdoppelt, wodurch eine frequenzverdoppelte Strahlung erhalten wird.

10. Laser nach Anspruch 1, ferner umfassend einen optisch nichtlinearen Kristall (115a', 115b'), der außerhalb des Laserresonators gelegen und so ausgebildet ist, dass er die Frequenz der Laserstrahlung der ersten Wellenlänge und/oder die Frequenz der Laserstrahlung der zweiten Wellenlänge verdoppelt, wodurch eine frequenzverdoppelte Strahlung erhalten wird.

11. Laser nach Anspruch 7, wobei der optisch nichtlineare Kristall (115c) im Laserresonator zwischen dem wellenlängenselektiven Transmissionselement (118) und der mehrschichtigen Spiegelstruktur gelegen ist.

12. Laser nach einem der vorhergehenden Ansprüche, wobei die Pumpquelle eine Pumplichtquelle (110) ist, so ausgebildet, dass sie Pumpstrahlung für die Verstärkerstruktur zum Erzeugen von Laserstrahlung im Laserresonator liefert.

13. Laser nach einem der Ansprüche 1 bis 11, wobei die Pumpquelle eine Pumpelektronenquelle ist, so ausgebildet, dass sie Pumpelektronen für die Verstärkerstruktur zum Erzeugen von Laserstrahlung im Laserresonator liefert.

14. Laser nach einem der vorhergehenden Ansprüche, wobei die ersten und zweiten aktiven Schichten (131, 132) ein Halbleitermaterial ausgewählt aus der Gruppe bestehend aus InₓGa₁₋ₓAs_{y}P_{1-y}, InₓGa₁₋ₓAs, GaₓIn₁₋ₓNyAs_{1-y} und Ga₁₋ₓAs_{y}Sb umfassen, wobei 0,0 < x < 1,0 und 0,0 < y < 1,0 ist, wobei für jede der ersten und zweiten aktiven Schichten x und y unabhängig auswählbar sind.

15. Laser nach einem der vorhergehenden Ansprüche, wobei die von den ersten und zweiten aktiven Schichten erzeugten ersten und zweiten Wellenlängen Werte von ungefähr 1060 bzw. 920 Nanometer aufweisen.

16. Laser nach einem der vorhergehenden Ansprüche, wobei die ersten aktiven Schichten (131) der Verstärkerstruktur Schichten aus einem Halbleitermaterial sind, das eine Zusammensetzung In_{0,1}Ga_{0,9}As aufweist, und die erste Wellenlänge 920 nm beträgt.

17. Laser nach Anspruch 1, wobei die zweiten aktiven Schichten (132) der Verstärkerstruktur Schichten aus einem Halbleitermaterial sind, das eine Zusammensetzung In_{0,25}Ga_{0,75}As aufweist, und die zweite Wellenlänge 1060 nm beträgt.

18. Laser nach einem der vorhergehenden Ansprüche, ferner umfassend eine Wärmesenke (112) in thermischem Kontakt mit der Laserpumpstruktur.

19. Laser nach einem der vorhergehenden Ansprüche, ferner umfassend eine Wärmesenke in thermischem Kontakt mit der Laserstruktur, wobei die Wärmesenke aus einem Material mit einem Wärmeausdehnungskoeffizienten ist, der zum Wärmeausdehnungskoeffizienten der Laserstruktur passt.

20. Lasersystem nach Anspruch 13, ferner umfassend ohmsche Kontakte, die so gelegen sind, dass sie Elektronen in die aktiven Schichten injizieren.

21. Lasersystem nach Anspruch 13, ferner umfassend eine Strombegrenzungsstruktur.

22. Lasersystem nach Anspruch 1, wobei die Laserstruktur ein GaAs-Substrat umfasst und die Doppelwellenlängenspiegelstruktur (102) AlₓGa₁₋ₓAs-Schichten und Al_{y}Ga_{1-y}As-Schichten aufweist, worin 0,0 ≤ x < 1,0 und 0,0 < y ≤ 1,0 ist.

## Revendications

1. Système laser comprenant :
une structure laser comprenant une structure de gain à couches multiples (103) adjacente à une structure miroir à double longueur d'onde (102) destinée à réfléchir la lumière avec une réflectivité élevée à une première longueur d'onde et une seconde longueur d'onde;
ladite structure de gain comprenant une pluralité de premières couches actives (131) destinées à générer de la lumière à la première longueur d'onde et une pluralité de secondes couches actives (132) destinées à générer de la lumière à la seconde longueur d'onde séparées par des couches barrières ;
un résonateur laser (102, 113, 114) comportant un axe de résonateur, ledit résonateur laser étant formé entre ladite structure miroir à double longueur d'onde (102) de ladite structure laser, et une structure miroir externe (113, 114) séparée de ladite structure de gain (103) ; et
une source de pompage (110) agencée pour fournir une énergie de pompage à ladite structure de gain (103) pour générer un rayonnement laser dans ledit résonateur laser ;
**caractérisé en ce que** ladite structure miroir externe comprend un premier miroir externe (113), un second miroir externe (114) et un élément sélecteur de longueurs d'onde transmissif (118) situé dans ledit résonateur laser pour séparer la lumière en fonction de la longueur d'onde sur deux trajets différents destinés à sélectionner ladite première longueur d'onde de ladite structure de gain afin d'atteindre le premier miroir externe (113) et à sélectionner ladite seconde longueur d'onde de ladite structure de gain afin d'atteindre le second miroir externe (114).

2. Système laser selon la revendication 1 dans lequel les premières couches actives (131) sont positionnées au niveau de ventres d'une première onde stationnaire dans le résonateur laser (102, 113) de la première longueur d'onde et les secondes couches actives (132) sont positionnées au niveau de ventres d'une seconde onde stationnaire dans le résonateur laser (102, 114) de la seconde longueur d'onde, et dans lequel le nombre de premières couches actives (131) et le nombre de secondes couches actives (132) commandent la puissance de sortie relative de la lumière à chacune des première et seconde longueurs d'onde.

3. Laser selon la revendication 1 ou 2, dans lequel la première longueur d'onde est plus courte que la seconde longueur d'onde, et lesdites secondes couches actives (132) sont plus nombreuses que lesdites premières couches actives (131) aux endroits où les ventres desdites ondes stationnaires desdites première et seconde longueurs d'onde coïncident.

4. Laser selon la revendication 1, 2 ou 3, dans lequel ladite structure miroir à double longueur d'onde (102) comprend une hétérostructure périodique, chacune des périodes comprenant au moins deux couches à indice de réfraction élevé H, au moins deux couches d'espacement S et au moins une couche à indice de réfraction faible L.

5. Laser selon la revendication 4, dans lequel ledit miroir à couches multiples est un empilement sous la forme de (L(HS)^{D})^{N}, dans lequel D et N sont des entiers positifs et D est supérieur à 1.

6. Laser selon la revendication 4, dans lequel ledit miroir à couches multiples est un empilement sous la forme de (H(LS)^{D})^{N}, dans lequel D et N sont des entiers positifs et D et N sont supérieurs à 1.

7. Laser selon l'une quelconque des revendications précédentes, comprenant en outre un cristal optiquement non linéaire (115) situé dans ledit résonateur laser, et agencé pour doubler au moins une parmi la fréquence du rayonnement laser à la première longueur d'onde et la fréquence du rayonnement laser à la seconde longueur d'onde.

8. Laser selon la revendication 7, dans lequel le cristal optiquement non linéaire (1156) est situé dans ledit résonateur laser entre ledit élément sélecteur de longueurs d'onde transmissif (118) et ledit premier miroir (113) et agencé pour doubler la fréquence dudit rayonnement laser à la première longueur d'onde, fournissant de ce fait un rayonnement à fréquence doublée.

9. Laser selon la revendication 7, dans lequel le cristal optiquement non linéaire (115a) est situé dans ledit résonateur laser entre ledit élément sélecteur de longueurs d'onde transmissif (118) et ledit second miroir (114) et agencé pour doubler la fréquence dudit rayonnement laser à seconde longueur d'onde, fournissant de ce fait un rayonnement à fréquence doublée.

10. Laser selon la revendication 1, comprenant en outre un cristal optiquement non linéaire (115a', 115b') situé en dehors dudit résonateur laser, et agencé pour doubler au moins une parmi la fréquence du rayonnement laser à première longueur d'onde et la fréquence du rayonnement laser à seconde longueur d'onde, fournissant de ce fait un rayonnement à fréquence doublée.

11. Laser selon la revendication 7, dans lequel le cristal optiquement non linéaire (115c) est situé dans ledit résonateur laser entre ledit élément sélecteur de longueurs d'onde transmissif et ladite structure miroir à couches multiples.

12. Laser selon l'une quelconque des revendications précédentes, dans lequel ladite source de pompage est une source de lumière de pompage (110) agencée pour fournir un rayonnement de pompage à ladite structure de gain pour générer un rayonnement laser dans ledit résonateur laser.

13. Laser selon l'une quelconque des revendications 1 à 11, dans lequel ladite source de pompage est une source d'électrons de pompage agencée pour fournir des électrons de pompage à ladite structure de gain pour générer un rayonnement laser dans ledit résonateur laser.

14. Laser selon l'une quelconque des revendications précédentes, dans lequel lesdites premières et secondes couches actives (131, 132) comprennent chacune un matériau semi-conducteur sélectionné dans le groupe consistant en InₓGa₁₋ₓAs_{y}P_{1-y}, InₓGa₁₋ₓAs, GaₓIn₁₋ₓN_{y}As_{1-y} et Ga₁₋ₓAs_{y}Sb, où 0,0 < x <1,0 et 0,0 <y <1,0, x et y pouvant chacun être sélectionné indépendamment pour chacune des premières et secondes couches actives.

15. Laser selon l'une quelconque des revendications précédentes, dans lequel les première et seconde longueurs d'onde générées par les premières et secondes couches actives ont des valeurs d'environ 1060 et 920 nanomètres, respectivement.

16. Laser selon l'une quelconque des revendications précédentes, dans lequel lesdites premières couches actives (131) de ladite structure de gain sont des couches d'un matériau semi-conducteur ayant pour composition In_{0,1}Ga_{0,9}As et ladite première longueur d'onde est de 920 nm.

17. Laser selon l'une quelconque des revendications précédentes, dans lequel lesdites secondes couches actives (132) de ladite structure de gain sont des couches d'un matériau semi-conducteur ayant pour composition In_{0,25}Ga_{0,75}As et ladite seconde longueur d'onde est de 1060 nm.

18. Laser selon l'une quelconque des revendications précédentes, comprenant en outre un dissipateur thermique (112) en contact thermique avec ladite structure de pompage laser.

19. Laser selon l'une quelconque des revendications précédentes, comprenant en outre un dissipateur thermique en contact thermique avec ladite structure laser, ledit dissipateur thermique étant d'un matériau ayant un coefficient d'expansion thermique qui correspond au coefficient d'expansion thermique de ladite structure laser.

20. Système laser selon la revendication 13, comprenant en outre des contacts ohmiques placés pour injecter des électrons dans lesdites couches actives.

21. Système laser selon la revendication 13, comprenant en outre une structure de confinement de courant.

22. Système laser selon la revendication 1, dans lequel ladite structure laser comprend un substrat en GaAs et ladite structure miroir à double longueur d'onde (102) comprend des couches en AlₓGa₁₋ₓAs et des couches en Al_{y}Ga_{1-y}As, où 0,0 ≤ x < 1,0 et 0,0 < y ≤ 1,0.
